# EUROPÄISCHE PATENTANMELDUNG

(11) **EP 0 796 930 A1**
(43) Veröffentlichungstag der Anmeldung: **24.09.1997**
(21) Anmeldenummer: 97104231.2
(22) Anmeldetag: 13.03.1997
(51) Int. Cl.: C23C 16/26, C23C 16/02, C23C 28/04, C23C 16/30

(54) **Verwendung einer elementaren Kohlenstoff enthaltenden Schicht auf Werkzeugen für spanende Formgebung**

(30) Priorität: 18.03.1996 DE 19610342
(71) Anmelder: Wälztechnik Saacke-Zorn GmbH & Co. K.G., D-75175 Pforzheim (DE)
(72) Erfinder: Fella, Roland, Dr.-Ing., 75053 Gondelsheim (DE)
(74) Vertreter: Twelmeier, Ulrich, Dipl.Phys.

(57) **Zusammenfassung**

Verwendung einer durch ein PVD-, PACVD- oder CVD-Verfahren abgeschiedenen, elementaren Kohlenstoff enthaltenden Schicht als Oberflächenschicht auf Werkzeugen für spanende Formgebung, insbesondere auf Wälzfräsern.

## Beschreibung

Es ist bekannt, die Oberfläche von Werkzeugen für spanende Formgebung mit Hartstoffen zu beschichten, um die Standzeit der Werkzeuge zu erhöhen. Hartstoffe, die für diesen Zweck eingesetzt werden, sind z.B. Chromkarbid, Titankarbid, Titannitrid und Bornitrid. Die DE 44 32 600 A1 offenbart die Verwendung einer durch ein PVD-Verfahren abgeschiedenen Titannitridschicht als Oberflächenschicht auf Stollenwälzfräsern. Die Beschichtung befindet sich sowohl auf der Gesichtsfläche als auch auf dem Rücken der Zähne des Stollenwälzfräsers. Das Gesicht der Zähne wird beim Fräsen am stärksten beansprucht, denn an ihm läuft der Span ab, der durch die am Übergang vom Gesicht zum Rücken der Zähne gebildete Schneide vom Werkstück abgehoben wird. Dadurch bildet sich am Gesicht in der Nachbarschaft der Schneidkante allmählich eine als Kolk bezeichnete flache Vertiefung aus. Hat der Kolk eine Tiefe von ungefähr 0,2 mm erreicht, werden die Zähne des Stollenwälzfräsers erneut geschärft. Die Hartstoffschicht wird dadurch vor allem am Gesicht der Zähne abgetragen und wird von Zeit zu Zeit durch Nachbeschichtung erneuert.

Aus der EP 0 534 905 A1 sind für die zerspanende Bearbeitung von Werkstoffen Werkzeuge bekannt, die eine Oberflächenschicht haben, die aus mindestens einer Verbindung aus mindestens einem Hauptgruppenelement der 6. Gruppe des Periodischen Systems einerseits und mindestens einem Nebengruppenelement der 5. und 6. Gruppe des Periodischen Systems der Elemente andererseits besteht. Insbesondere besteht die Oberflächenschicht aus Molybdändisulfid (MoS₂). Bei der Bearbeitung von Nichteisen-Legierungen mit Fräsern, die mit MoS₂ beschichtet sind, erreicht man eine höhere Lebensdauer der Fräser. Nachteilig dabei ist jedoch, daß MoS₂ sehr weich ist, bei Beanspruchung stark abgetragen wird und bei höheren Temperaturen mit dem Luftsauerstoff zu MoO₂ oder zu MoO₃ reagiert, welche störende Schleifpartikel bilden.

Der vorliegenden Erfindung liegt die **Aufgabe** zugrunde, einen weiteren Weg aufzuzeigen, wie die Lebensdauer von Werkzeugen für spanende Formgebung erhöht werden kann, ohne daß man damit rechnen muß, daß sich beim Arbeiten mit den Werkzeugen störende Reaktionsprodukte bilden.

Erfindungsgemäß wird diese Aufgabe dadurch gelöst, daß man auf den Werkzeugen für spanende Formgebung, insbesondere auf Wälzfräsern, eine durch ein PVD-, CVD- oder PACVD-Verfahren abgeschiedene, elementaren oder metallhaltigen Kohlenstoff enthaltende Schicht als Oberflächenschicht verwendet. Damit gelingt es, die Lebensdauer von spanenden Werkzeugen verglichen mit solchen, die eine herkömmliche Hartbeschichtung tragen, deutlich zu verbessern, obwohl es sich bei der Kohlenstoffschicht nicht um eine harte Schicht handelt. Es handelt sich bei der Kohlenstoffschicht aber auch nicht um eine ausgesprochene Schmiermittelschicht, denn der Kohlenstoff wird in Anwendung eines PVD-, CVD- oder PACVD-Verfahrens nicht als Graphit-Modifikation abgeschieden, sondern vorwiegend amorph. Der amorphe Kohlenstoff hat nicht die gute Schmierfähigkeit wie Graphit oder wie MoS₂, welche man sich nach der Lehre der EP 0 534 905 A1 zunutze macht; im Gegenteil: Nach einem PVD-, CVD- oder PACVD-Verfahren abgeschiedener Kohlenstoff enthält außer amorph abgeschiedenem Kohlenstoff auch Kohlenstoff in Form von diamantähnlichen Mikrokristallen, welche in den amorphen Kohlenstoff eingebettet sind. Ob die besondere Eignung des durch ein PVD-, CVD- oder PACVD-Verfahren abgeschiedenen Kohlenstoffs als verschleißmindernde Beschichtung auf spanenden Werkzeugen vielleicht auf dem Verbund von amorphem Kohlenstoff mit diamantähnlichen Mikrokristallen beruht oder andere Ursachen hat, ist noch nicht bekannt. Erste Versuche zeigen jedoch, daß die Standzeit erfindungsgemäßer Kohlenstoffschichten insbesondere auf dem Rücken der Schneidwerkzeuge, auf welchem die Späne nicht ablaufen, besonders hoch ist. Die vor allem bei Wälzfräsern dort auftretende Reibung ist verglichen mit Werkzeugen, die in herkömmlicher Weise mit Hartstoffen beschichtet sind, deutlich geringer. Damit ist auch die reibungsbedingte Erwärmung des Werkzeugs geringer, und das wirkt sich nicht nur unmittelbar am Rücken der Zähne (Freifläche) des Wälzfräsers aus, sondern auch am Gesicht (der Spannfläche) der Zähne, wo sich üblicherweise der Kolk bildet. Obwohl die Kohlenstoffschicht dort, wo sich der Kolk bildet, wegen ihrer verglichen mit einem Hartstoff geringen Härte und wegen der großen Löslichkeit von Kohlenstoff in Eisenwerkstoffen nicht übermäßig beständig ist, wird die kritische Kolktiefe von ungefähr 0,2 mm, nach deren Erreichen ein Nachschärfen der Zähne des Wälzfräsers angezeigt ist, wesentlich später erreicht als im Falle einer reinen Hartstoffbeschichtung. Dabei bleibt die Oberflächentemperatur des Werkzeugs so niedrig, daß keine schädliche Kohlenstoffdiffusion in das bearbeitete Werkstück stattfindet, so daß auch Eisenwerkstoffe, deren oberflächliches Aufkohlen unerwünscht ist, mit erfindungsgemäßen Werkzeugen bearbeitet werden können.

Um den mit der Erfindung erreichten Fortschritt zu beleuchten, wurden mit unterschiedlich beschichteten Stollenwälzfräsern Flachfräsversuche unter nachstehenden Schnittbedingungen durchgeführt:
- Bearbeitetes Material:: 42 CrMo4
- Grundhärte des Materials:: 65,6 HR_{c}
- Länge eines Schnitts::: 250 mm
- Breite eines Schnitts::: 30 mm
- Drehzahl des Stollenwälzfräsers:: 2,24 U/min
- Schnittgeschwindigkeit:: 81 m/min
- Vorschub:: 400 mm/min
- Vorschub/U:: 1,75 mm/U.

Untersucht wurde, welche Kolktiefe sich nach 12 Schnitten und nach 30 Schnitten unter diesen Schnittbedingungen einstellte. Die Ergebnisse sind in dem beigefügten Diagramm dargestellt.

Die Variante 1 zeigt das Verhalten eines ursprünglich mit Titannitrid beschichteten Stollenwälzfräsers, nachdem dieser geschärft wurde; diese Variante zeigte die schlechtesten Ergebnisse, nach 30 Schnitten wurde eine Kolktiefe von 200 µm erreicht, die ein erneutes Schärfen erforderlich macht.

Die Variante 2 unterscheidet sich von der Variante 1 darin, daß die Stollenwälzfräser, nachdem sie nachgeschärft waren, mittels Arc-Verdampfung mit Titannitrid nachbeschichtet wurden. Es zeigt sich, daß die Nachbeschichtung die Standzeit des Werkzeugs deutlich erhöht: Nach 30 Schnitten betrug die Kolktiefe lediglich 65 µm verglichen mit 200 µm bei Stollenwälzfräsern, welche zwar nachgeschärft, aber nicht nachbeschichtet wurden.

Noch besser verhalten sich erwartungsgemäß Stollenwälzfräser, die mit Titannitrid beschichtet sind, bei ihrem erstmaligen Einsatz (Variante 3). Bei ihnen beträgt die Kolktiefe nach 12 Schnitten lediglich 10 µm, nach 30 Schnitten 52 µm. Werden die Stollenwälzfräser jedoch erneut geschärft, zeigen sie das Verhalten der Variante 1.

Bei 12 Schnitten eine etwas größere Kolktiefe und bei 30 Schnitten eine etwas geringere Kolktiefe als bei einem Stollenwälzfräser mit einer durch Arc-Verdampfung gebildeten Titannitridschicht zeigten Stollenwälzfräser mit einer nach dem Balzers-Verfahren erzeugten Titannitridschicht (Variante 4).

Die Variante 5 zeigt das Verhalten einen Stollenwälzfräsers, der rundum mit Titannitrid und darüber mit Kohlenstoff beschichtet ist. Dieser Stollenwälzfräser zeigt die besten Ergebnisse: Nach 12 Schnitten eine Kolktiefe von nur 10 µm und nach 30 Schnitten eine Kolktiefe von nur 15 µm. In der Variante 6 wurde dieser Stollenwälzfräser geschärft, aber nicht erneut beschichtet. Die Kolktiefe betrug dann nach 30 Schnitten 65 µm, nicht mehr als bei einem mit Titannitrid nachbeschichteten Stollenwälzfräser und nur 1/3 der Kolktiefe eines mit Titannitrid, aber nicht mit Kohlenstoff beschichteten, geschärften, aber nicht nachbeschichteten Stollenwälzfräsers. Der Kostenvorteil, der sich wegen der höheren Lebensdauer gegenüber einem im herkömmlicher Weise mit Titannitrid beschichteten Stollenwälzfräser ergibt, ist also beträchtlich.

Die Dicke der abgeschiedenen Kohlenstoffschicht beträgt zweckmäßigerweise zwischen 1 µm und 3 µm, vorzugsweise ungefähr 2 µm. Für das Abscheiden der Kohlenstoffschichten kommen praktisch alle PVD- und PACVD-Verfahren infrage. So kann der Kohlenstoff z.B. aus einer Acetylenatmosphäre heraus abgeschieden werden, oder durch Arc-Verdampfen von Kohlenstoff aus einem massiven Kohlenstofftarget. Auch Plasma-CVD-Abscheideverfahren sind anwendbar. Um möglichst fest haftende Beschichtungen zu erhalten, werden die zu beschichtenden Werkzeuge in der Beschichtungskammer vorzugsweise auf eine Temperatur von 200°C bis 300°C aufgeheizt, bevor die Beschichtung beginnt.

Die Oberflächenschicht kann aus reinem Kohlenstoff bestehen, doch können in den Kohlenstoff auch Fremdsubstanzen, insbesondere Hartstoffe eingelagert sein, welche mit abgeschieden werden. Die Kohlenstoffschicht kann unmittelbar auf dem Werkzeugstahl liegen. Vorzugsweise befindet sich jedoch zwischen der Kohlenstoffschicht und dem Werkzeugstahl eine Zwischenschicht aus einem Hartstoff, insbesondere aus Titannitrid oder Titankarbid. Die Kombination aus einer Hartstoffschicht mit darüberliegender Kohlenstoffschicht führt zu einer besonders geringen Kolkbildung.

Die Hartstoffschicht und die Kohlenstoffschicht können nacheinander abgeschieden werden. Vorzugsweise sieht man einen allmählichen Übergang von der Hartstoffschicht zur Kohlenstoffschicht vor, was zu einer besonders innigen Verzahnung der beiden Schichten führt und die Haftung sowie die Beständigkeit der Kohlenstoffschicht auf dem Werkzeug verbessert. Einen solchen Schichtaufbau kann man dadurch erzeugen, daß man in ein und derselben Beschichtungskammer zunächst mit dem Abscheiden der Hartstoffschicht beginnt und nach einiger Zeit eine zunehmende Veränderung der Zusammensetzung der Atmosphäre vornimmt mit dem Ziel, die Abscheiderate des Hartstoffs zu vermindern unter gleichzeitiger Steigerung der Abscheiderate von Kohlenstoff, bis schließlich vorzugsweise nur noch Kohlenstoff abgeschieden wird.

Eine andere Möglichkeit besteht darin, einen Hartstoff und Kohlenstoff gemeinsam abzuscheiden, beispielsweise das System "Titankarbid und Kohlenstoff", indem dafür gesorgt wird, daß in der Atmosphäre der Beschichtungskammer Kohlenstoff in solchem Überschuß vorhanden ist, daß er im Überschuß abgeschieden wird.

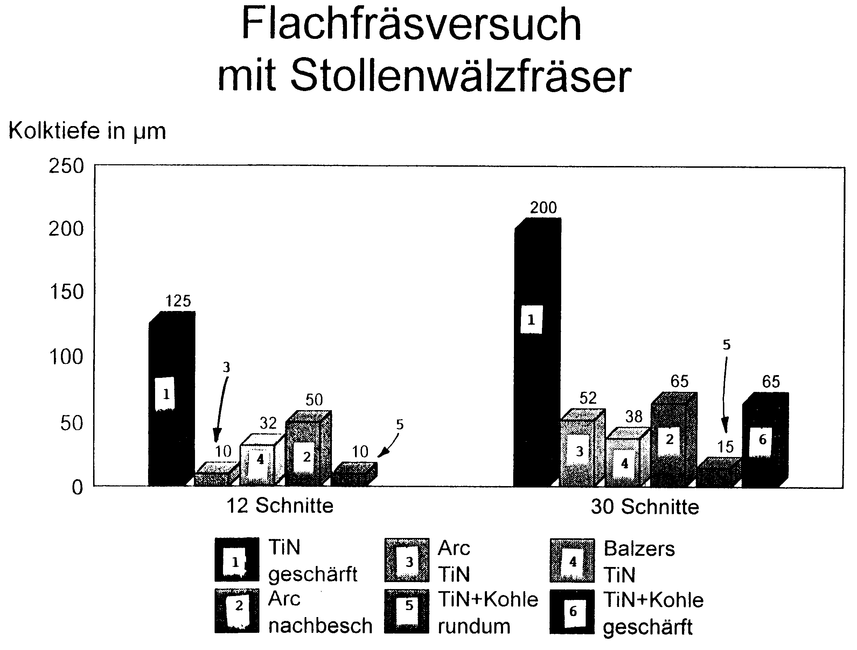

## Patentansprüche

1. Verwendung einer durch ein PVD-, PACVD- oder CVD-Verfahren abgeschiedenen, elementaren Kohlenstoff enthaltenden Schicht als Oberflächenschicht auf Werkzeugen für spanende Formgebung, insbesondere auf Wälzfräsern.

2. Verwendung nach Anspruch 1, bei welcher die Oberflächenschicht überwiegend oder vollständig aus Kohlenstoff besteht.

3. Verwendung nach Anspruch 1 oder 2, bei welcher der Kohlenstoff vorwiegend amorph vorliegt.

4. Verwendung nach einem der vorstehenden Ansprüche, bei welcher in die Oberflächenschicht Hartstoffe eingelagert sind.

5. Verwendung nach einem der vorstehenden Ansprüche, bei welcher die Kohlenstoffschicht auf einer Hartstoffschicht liegt.

6. Verwendung nach Anspruch 5, bei welcher die Hartstoffschicht und die Kohlenstoffschicht allmählich ineinander übergehen.

7. Verwendung nach einem der vorstehenden Ansprüche, bei welcher in die Kohlenstoffschicht Metalle eingelagert sind.

8. Verfahren zum Erzeugen eines Schichtaufbaus für eine Verwendung gemäß einem der Ansprüche 4 bis 7, **dadurch gekennzeichnet**, daß die Hartstoffe und /oder Metalle und der Kohlenstoff in ein- und derselben Beschichtungskammer durch ein PVD-, PACVD- oder CVD-Verfahren abgeschieden werden.

9. Verfahren nach Anspruch 8, **dadurch gekennzeichnet**, daß die Hartstoffe und der Kohlenstoff nacheinander abgeschieden werden.

10. Verfahren nach Anspruch 8, **dadurch gekennzeichnet**, daß die Hartstoffe und der Kohlenstoff wenigstens zeitweise gemeinsam abgeschieden werden.

11. Verfahren nach Anspruch 10, **dadurch gekennzeichnet**, daß in einer Übergangsphase der Abscheidung die Abscheiderate der Hartstoffe allmählich verringert und die Abscheiderate des Kohlenstoffs allmählich erhöht wird.

12. Verfahren nach einem der vorstehenden Ansprüche, **dadurch gekennzeichnet**, daß das Werkzeug vor der Beschichtung mit Kohlenstoff vorgeheizt wird, insbesondere auf eine Temperatur von 200°C bis 300°C.
